# EUROPEAN PATENT APPLICATION

(11) **EP 2 020 837 A2**
(43) Date of publication of application: **04.02.2009**
(21) Application number: 08159299.0
(22) Date of filing: 27.06.2008
(51) Int. Cl.: H05K 7/20

(54) **Plasma display apparatus**

(30) Priority: 02.08.2007 KR 20070077726
(71) Applicant: Samsung SDI Co., Ltd., Suwon-si, Gyeonggi-do (KR)
(72) Inventor: Choi, Jin-Seek, Gyeonggi-do (KR); Hwang, Hui-Yun, Gyeonggi-do (KR); Lee, Ik-Sang, Gyeonggi-do (KR)
(74) Representative: Bonnans, Arnaud

(57) **Abstract**

A plasma display apparatus that includes a plasma display panel (11), a chassis base (15), a driving circuit (17), a flexible printed circuit (27), a driver integrated circuit (25) and a first (41, 51) and second (42) thermal conductive silicone. The chassis base (15) is provided at a side of the plasma display panel (11). The driving circuit unit (17) is provided at a side of the chassis base (11). The flexible printed circuit (27) electrically connects an electrode (12) of the plasma display panel (11) to the driving circuit unit (17). The driver integrated circuit (25) is connected to the flexible printed circuit (27). The first thermal conductive silicone (41, 51) is provided between the driver integrated circuit (25) and the chassis base (15). The second thermal conductive silicone (42) is provided, in another embodiment, between the driver integrated circuit (25) and the chassis base (15) and encloses an extending portion of the driver integrated circuit (25). The first and second thermal conductive silicone (41, 42, 51) dissipate heat, absorb vibrations and reduce noise.

## Description

The present invention relates to a plasma display apparatus and, more particularly, to a plasma display apparatus that is designed to improve thermal dissipation efficiency, simplify a manufacturing process, and reduce noise by enclosing a driver integrated circuit with silicone.

A plasma display apparatus is configured to display an image on a plasma display panel (PDP) using plasma generated by gas discharge. In the plasma display apparatus, electrodes of the PDP are electrically connected to a drive circuit unit through a flexible printed circuit (FPC). A driver integrated circuit is formed on the FPC. The driver integrated circuit selectively applies a voltage to discharge cells of the PDP in accordance with a control signal transmitted from the drive circuit unit.

A chip on board (COB) where the driver integrated circuit is provided on a printed circuit board (PCB) and a chip on film (COF) where the driver integrated circuit is provided on a film forming the FPC are connection structures for connecting the FPC to the driver integrate circuit. Recently, a tape carrier package (TCP) that is small and inexpensive has been widely used.

When the TCP is used, the manufacturing cost can be further reduced as compared with when the COF is used. However, since the driver integrated circuit of the TCP is small and no thermal dissipation mechanism is provided, the TCP has lower thermal dissipation efficiency as compared with the COF.

Therefore, thermal grease is applied between a surface of the driver integrated circuit and a chassis base (or a reinforcing member formed on the chassis base), and a thermal dissipation pad is provide on the other surface of the driver integrated circuit to dissipate heat.

However, the thermal dissipation effect of the thermal dissipation pad is slight and a process for applying the thermal grease is complicated. Therefore, the overall manufacturing process is longer, more complex, time consuming and expensive.

Accordingly, what is required is a plasma display device that improves heat dissipation, reduces vibration and noise while reducing the time and cost of production.

The above information is only for enhancement of understanding of the background of the invention and therefore it may contain information that does not form the prior art that is already known to a person of ordinary skill in the art.

It is therefore, an object of the present invention to provide an improved plasma display apparatus.

It is another object to provide a plasma display apparatus that exhibits improved heat dissipation, reduced vibration, and diminished noise.

It is still another object to provide a plasma display apparatus that is amenable to manufacture in reduced time and at lower cost per unit.

Exemplary embodiments provide a plasma display apparatus that is configured to improve a thermal dissipation effect of a driver integrate circuit and simplify a manufacturing process by directly applying thermal conductive silicone on the front and rear surfaces of the driver integrated circuit.

Exemplary embodiments also provide a plasma display apparatus that can reduce vibration and noise generated on a PDP by applying thermal conductive silicone on the front and rear surfaces of the driver integrated circuit.

In an exemplary embodiment of the present invention, a plasma display apparatus includes a plasma display panel, a chassis base provided at a side of the plasma display panel, a driving circuit unit provided at a side of the chassis base, a flexible printed circuit electrically connecting an electrode of the plasma display panel to the driving circuit unit, a driver integrated circuit connected to the flexible printed circuit, and first thermal conductive silicone provided between the driver integrated circuit and the chassis base.

The driver integrated circuit may extend from a surface of the flexible printed circuit toward the chassis base, and the first thermal conductive silicone may fully enclose an extending portion of the driver integrated circuit.

The first thermal conductive silicone may include at least one of the materials of aluminium oxide, zinc oxide, and titanium oxide.

The plasma display apparatus may further include a thermal dissipation plate spaced apart from the other surface of the flexible printed circuit and second thermal conductive silicone provided between the driver integrated circuit and the thermal dissipation plate.

The driver integrated circuit may extend from the other surface of the flexible printed circuit toward the heat dissipation plate, and the second thermal conductivity silicone may fully enclose an extending portion of the driver integrated circuit.

The second thermal conductive silicone may include at least one of aluminium oxide, zinc oxide, and titanium oxide.

The chassis base may include a main chassis adhered to a side of the plasma display panel and a sub-chassis extending from the main chassis and spaced apart from the plasma display panel, wherein the first thermal conductive silicone is adhered to the sub-chassis.

The sub-chassis may include a first protrusion extending from a surface of the main chassis away from the plasma display panel, a parallel portion extending from the first protrusion in parallel with the main chassis, and a second protrusion extending from the parallel portion toward the plasma display panel.

The driver integrated circuit may be formed opposite to the second protrusion.

The flexible printed circuit may be a tape carrier package.

In another exemplary embodiment of the present invention, a plasma display apparatus may include a plasma display panel, a chassis base provided at a side of the plasma display panel, a driving circuit unit provided at a side of the chassis base, a flexible printed circuit electrically connecting an electrode of the plasma display panel to the driving circuit unit, and a driver integrated circuit connected to the flexible printed circuit, wherein the driver integrated circuit extends from the flexible printed circuit toward an opposite side of the chassis base and second thermal conductive silicone is provided between the driver integrated circuit and the chassis base and encloses an extending portion of the driver integrated circuit.

The plasma display apparatus may further includes first thermal conductive silicone provided between the flexible printed circuit corresponding to the driver integrated circuit and the chassis base.

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:
FIG. 1 is an exploded perspective view of a plasma display apparatus according to a first exemplary embodiment of the present invention.
FIG. 2 is a sectional view taken along line II-II of FIG. 1.
FIG. 3 is a sectional view of a plasma display apparatus according to a second exemplary embodiment of the present invention.

The present invention will be described more fully hereinafter with reference to the accompanying drawings, in which exemplary embodiments of the invention are shown. Like reference numerals designate like elements throughout the specification. Further, the drawings and description are to be regarded as illustrative in nature and not restrictive.

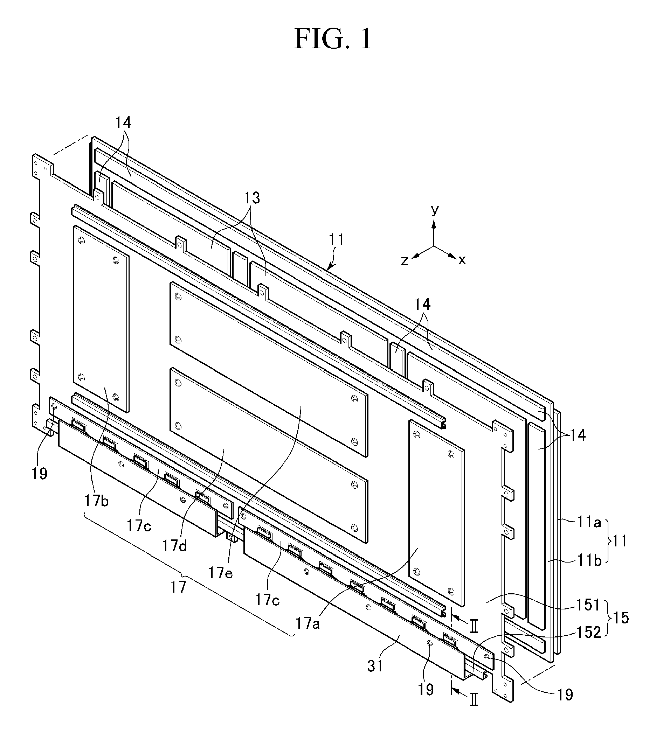

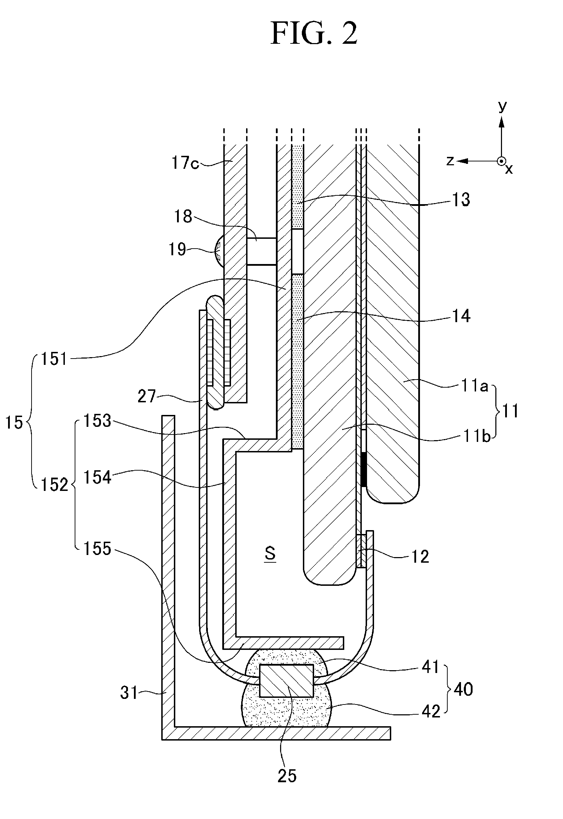

FIG. 1 is an exploded perspective view of a plasma display apparatus according to a first exemplary embodiment of the present invention, and FIG. 2 is a sectional view taken along line II-II of FIG. 1.

Referring to FIGS. 1 and 2, a plasma display apparatus of a first exemplary embodiment of the present invention includes a PDP 11, a plurality of thermal dissipation sheets 13, a chassis base 15, and a printed circuit board assembly (PBA) 17.

The PDP 11 includes front and rear substrates 11 a and 11 b. The PDP 11 displays an image using gas discharge occurring in a space defined between the front and rear substrates 11a and 11 b. In addition, a feature of this exemplary embodiment of the present invention relates to a peripheral structure of the PDP 11 rather than to the PDP itself. Therefore, the general structure of the PDP 11 will not be described herein.

The thermal dissipation sheets 13 are provided on a rear surface of the PDP 11 to dissipate heat generated by the PDP 11 to an external side. The thermal dissipation sheets 13 may be formed of a variety of materials such as acryl-based material, a graphite-based material, a metal-based material, a carbon-nanotube-based material, and the like.

The chassis base 15 is adhered to the rear surface of the PDP 11 by a double-sided adhesive tape 14.

The chassis base 15 includes a main chassis 151 layered on the rear surface of the PDP 11 and a sub-chassis 152 extending from a lower end of the main chassis 151.

The sub-chassis 152 has a first protrusion 153 extending from a rear surface of the main chassis 151, a parallel portion 154 extending from the first protrusion 153 in parallel with the main chassis 151, and a second protrusion 155 extending from the parallel portion 154 toward the PDP 11.

The parallel portion 154 is spaced apart from the PDP 11 and thus a space is defined between the parallel portion 154 and the PDP 11.

The PBA 17 is mounted on the rear surface of the chassis base 15 and electrically connected to the PDP. The PBA 17 is disposed on a plurality of bosses 18 provided on the chassis base 15 and fixed by setscrews 19 screwed to the respective bosses 18.

The PBA 17 includes a sustain electrode drive board 17a controlling a sustain electrode (not shown), a scan electrode drive board 17b controlling a scan electrode (not shown), an address buffer board 17c controlling an address electrode 12, a logic board 17d generating signals for driving the address, sustain, and scan electrodes and applying the generated signals to the corresponding boards, and a power supply board 17e supplying electric power required for driving the boards.

The address buffer board 17c is connected to the address electrode 12 through an FPC 27. The address buffer board 17c may be formed of a flexible printed circuit (FPC).

Meanwhile, the FPC 27 may be formed of a TCP on which a driver integrated circuit 25 generating a control signal that is applied to the address electrode 12 is formed.

The driver integrated circuit 25 may extend from a surface of the FPC 27 toward the chassis base 15 and extend from the other surface of the FPC 27 toward a thermal dissipation plate 31. In this exemplary embodiment, the driver integrated circuit 25 extends away from both sides of the FPC 27.

In the present exemplary embodiment, the driver integrated circuit 25 is opposite to the second protrusion 155 of the chassis base 15. However, the present invention is not limited to this configuration.

In order to dissipate the heat generated by the driver integrated circuit 25, the driver integrated circuit 25 is covered with thermal conductive silicone 40. Meanwhile, the thermal conductive silicone 40 may include a thermal conductive material selected from the group of materials comprising aluminium oxide, zinc oxide, titanium oxide, or a combination thereof.

First thermal conductive silicone 41 is provided between the driver integrated circuit 25 and the second protrusion 155, and second thermal conductive silicone 42 is provided between the driving integrated circuit 25 and the thermal dissipation plate 31.

The first thermal conductive silicone 41 is directly applied to a TCP film (not shown) covering the FPC 27 and the driver integrated circuit 25 such that it can completely enclose an extending portion of the driver integrated circuit 25. Further, the first thermal conductive silicone 41 is adhered to the second protrusion 155 of the chassis base 15.

Meanwhile, the parallel portion 154 of the sub-chassis 152 is spaced apart from the PDP 11 by a predetermined distance and thus a thermal dissipation space S is defined between the parallel portion 154 and the rear surface of the PDP 11. Accordingly, the heat generated from the driver integrated circuit 25 is transferred to the second protrusion 155 through the first thermal conductive silicone 41 and thus heat can be effectively dissipated to the thermal dissipation space S.

The second thermal conductive silicone 42 is formed to fully enclose an extending portion of the driver integrated circuit 25 and adhered to the thermal dissipation plate 31.

When the first thermal conductive silicone 41 and the second thermal conductive silicone 42 are provided to enclose the driver integrated circuit 25, the temperature can be further reduced by 2-3°C as compared with the contemporary art where the thermal grease and the thermal dissipation pad are provided on opposite sides of the driver integrated circuit.

Meanwhile, since the thermal conductive silicone 40 has a thermosetting property, it is hardened after being applied to the driver integrated circuit 25. After the thermal conductive silicone 40 is hardened, it is coupled to the second protrusion 155 and the thermal dissipation plate 31 in the course of mounting the FPC 27 on the chassis base 15 and the heat dissipation plate 31.

Meanwhile, according to the contemporary art, the thermal grease is applied in a state where the driver integrated circuit is disposed opposite to the chassis base. In this case, it is inconvenient to do this work and thus the manufacturing process is extended becoming more complex, time consuming and expensive to manufacture.

On the other hand, according to the present exemplary embodiment, the process is completed by simply attaching the thermal conductive silicone 40 to the second protrusion 155 and the thermal dissipation plate 31 in a state where the thermal conductive silicone 40 is applied to the driver integrated circuit 25 of the FPC 27 and hardened. Therefore, the manufacturing process can be simplified and the processing time can be reduced.

Furthermore, the thermal conductive silicone 40 can absorb a variety of vibrations generated from the PDP 11 and thus reduce noise. That is, the vibrations generated from the PDP 11 are transmitted to the FPC 27 through the address electrode 12. At this point, the thermal conductive silicone 40 applied on the FPC 27 and the driver integrated circuit 25 absorbs the vibrations. The vibrations generated from the PDP 11 may be transmitted through the chassis base 15, in the course of which the vibrations are absorbed by the first thermal conductive silicone 41.

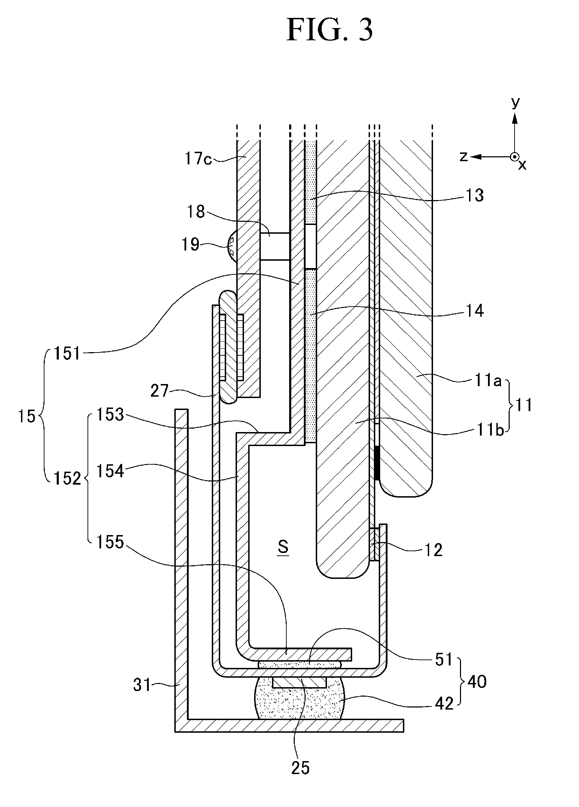

FIG. 3 is a sectional view of a plasma display apparatus according to a second exemplary embodiment of the present invention.

The driver integrated circuit 25 extends from the FPC 27 toward an opposite side of the chassis base 15. Therefore, the first thermal conductive silicone 41 is located between the FPC 27 and the chassis base 15 and the second thermal conductive silicone 42 is located between the driver integrated circuit 25 and the thermal dissipation plate 31.

The thermal dissipation silicone 51 dissipates the heat from the FPC 27 corresponding to the driver integrated circuit 25 toward the chassis base 15 and the second thermal conductive silicone 42 dissipates the heat toward the thermal dissipation plate 31 by fully enclosing the protruded driver integrated circuit 25.

According to the present invention, the heat dissipation efficiency can be improved and the manufacturing process of the plasma display apparatus can be simplified. Further, since the thermal conductive silicone absorbs vibrations generated from the PDP, noise can be attenuated.

## Claims

1. A plasma display apparatus comprising:
a plasma display panel (11);
a chassis base (15) provided at a side of the plasma display panel (11);
a driving circuit unit (17, 17c) provided at a side of the chassis base (15);
a flexible printed circuit (27) electrically connecting an electrode (12) of the plasma display panel (11) to the driving circuit unit (17, 17c);
a driver integrated circuit (25) connected to the flexible printed circuit (27); and
a thermal conductive silicone (41, 42, 51) provided between the driver integrated circuit (25) and a structure (15, 155, 31).

2. The plasma display apparatus of claim 1, wherein said thermal conductive silicone is a first thermal conductive silicone (41, 51) provided between the driver integrated circuit (25) and the chassis base (15).

3. The plasma display apparatus of claim 2, wherein the driver integrated circuit (25) extends from a surface of the flexible printed circuit (27) toward the chassis base (15), and
the first thermal conductive silicone (41) fully encloses an extending portion of the driver integrated circuit (25).

4. The plasma display apparatus of claim 3, further comprising a thermal dissipation plate (31) spaced apart from the other surface of the flexible printed circuit (27) and second thermal conductive silicone (42) provided between the driver integrated circuit (25) and the thermal dissipation plate (31).

5. The plasma display apparatus of claim 4, wherein the driver integrated circuit (25) extends from the other surface of the flexible printed circuit (27) toward the heat dissipation plate (31), and
the second thermal conductivity silicone (42) fully encloses an extending portion of the driver integrated circuit (25).

6. The plasma display apparatus of claim 1, wherein
the driver integrated circuit (25) extends from the flexible printed circuit (27) toward an opposite side of the chassis base (15), and
said thermal conductive silicone is a second thermal conductive silicone (42) provided between the driver integrated circuit (25) and a thermal dissipation plate (31) and enclosing an extending portion of the driver integrated circuit (25).

7. The plasma display apparatus of claim 6, further comprising first thermal conductive silicone (51) provided between the flexible printed circuit (27) corresponding to the driver integrated circuit (25) and the chassis base (15).

8. The plasma display apparatus of any one of claims 2 to 5 and 7, wherein the first thermal conductive silicone (41, 51) includes at least one of aluminium oxide, zinc oxide, and titanium oxide.

9. The plasma display apparatus of any one of claims 4 to 7, wherein the second thermal conductive silicone (42) includes at least one of aluminium oxide, zinc oxide, and titanium oxide.

10. The plasma display apparatus of any of claims 2 to 5, 7 and 8, wherein the chassis base (15) comprises:
a main chassis (151) adhered to a side of the plasma display panel (11); and
a sub-chassis (152) extending from the main chassis (151) and spaced apart from the plasma display panel (11),
wherein the first thermal conductive silicone (41, 51) is adhered to the sub-chassis (152).

11. The plasma display apparatus of claim 10, wherein the sub-chassis (152) comprises:
a first protrusion (153) extending from a surface of the main chassis (151) away from the plasma display panel (11);
a parallel portion (154) extending from the first protrusion (153) in parallel with the main chassis (151); and
a second protrusion (155) extending from the parallel portion (154) toward the plasma display panel (11).

12. The plasma display apparatus of claim 11, wherein the driver integrated circuit (25) is formed opposite to the second protrusion (155).

13. The plasma display apparatus of any one of claims 1 to 12, wherein the flexible printed circuit (27) is a tape carrier package.
